# EUROPEAN PATENT APPLICATION

(11) **EP 3 229 268 A1**
(43) Date of publication of application: **11.10.2017**
(21) Application number: 15865455.8
(22) Date of filing: 27.11.2015
(51) Int. Cl.: H01L 23/373, H01L 23/12, H01L 23/36

(54) **HEAT-DISSIPATING SUBSTRATE AND METHOD FOR MANUFACTURING SAME**

(30) Priority: 05.12.2014 JP 2014246636
(71) Applicant: Superufo291 Tec, Kyoto-shi, Kyoto 604-0924 (JP)
(72) Inventor: FUKUI, Akira, Kyoto-shi Kyoto 604-0963 (JP)
(74) Representative: Hoeger, Stellrecht & Partner Patentanwälte mbB
(86) International application number: PCT/JP2015/083480
(87) International publication number: WO 2016/088687

(57) **Abstract**

A heat dissipation substrate having the maximum value of the coefficient of linear expansion of 10 ppm/K or less in any direction in a plane parallel to the surface within a temperature range from room temperature to 800°C as well as a thermal conductivity of 250 W/m•K or higher at 200°C is produced by densifying an alloy composite of CuMo or CuW composed of Cu and coarse powder of Mo or W and subsequently cross-rolling the same alloy composite.

## Description

### TECHNICAL FIELD

The present invention relates to a heat radiation substrate made of CuMo or CuW to be installed in a semiconductor package of a high-performance semiconductor module (such a package is hereinafter simply called the "package"), the substrate having (1) a suitable coefficient of linear expansion for semiconductor modules, (2) a high degree of thermal conductivity, and (3) a metallic layer with few defects on its surface. The present invention also relates to a method for producing such a substrate.

### BACKGROUND ART

Semiconductor modules have various applications, such as the LSI, IGBT power semiconductor, radio-wave/optical communication semiconductor, laser, LED and sensor. Those modules have a wide variety of structures depending on the required performances for such applications. A semiconductor module is an extremely sophisticated precision device composed of various materials having different coefficients of linear expansion along with different degrees of thermal conductivity. The heat dissipation substrate used in the package of the semiconductor module also has a wide variety of composite materials and shapes proposed.

The heat dissipation substrate for a semiconductor module must have a suitable coefficient of linear expansion for the semiconductor module to secure the performance and life of the semiconductor device in the process of manufacturing the package and soldering the semiconductor device. It also needs to have a high degree of thermal conductivity in order to cool the semiconductor device to secure its performance and life. It is also extremely important that the substrate should allow for a satisfactory plating to enable the joining of various members and semiconductor devices.

Heat dissipation substrates can be roughly classified by their forms as follows: a sub-mount of a few millimeters square with a thickness of 3 mm or less; a flat plate; a threaded flat plate; and a three-dimensional shape. A manufacturing method by which those shapes can be easily obtained is desired.

Originally, copper (Cu) was used for high-performance heat dissipation substrates. However, with the recent improvement in the performance of the semiconductor modules, the amount of heat generation has considerably increased, and the use of Cu has caused problems in relation to the production process and durability of the package as well as the operation life of the semiconductor device, since the coefficient of linear expansion of Cu is too large. Accordingly, there has been an increasing demand for a heat dissipation substrate having a coefficient of linear expansion compatible with high-performance semiconductor modules.

To address this problem, a CuW-based heat dissipation substrate has been developed whose coefficient of linear expansion can be modified or adjusted so as to match with the coefficient of linear expansion for high-performance semiconductor modules. A CuMo-based heat dissipation substrate has also been developed for the purpose of cost reduction and high thermal conductivity. AlSiC has also been developed for a package which is produced without silver soldering and is required to be lightweight. However, any of these composite materials has the problem that an attempt to achieve a suitable coefficient of linear expansion for a semiconductor module causes the thermal conductivity to be considerably lower than that of Cu.

The CuW-based heat dissipation substrate has a maximum coefficient of linear expansion of 10 ppm/K or less within a temperature range from 25°C (room temperature, which is hereinafter abbreviated as "RT") to 800°C. Such a coefficient of linear expansion is suitable for semiconductor modules. Therefore, the substrate allows various members having different coefficients of linear expansion to be silver-soldered at a high temperature of 800°C in the package production process. The substrate also causes no problem in the soldering process performed at a temperature within a range from 200°C to 400°C when the substrate is used for a semiconductor device. It is also compatible with the junction temperature for Si or GaAs devices which have been commonly used in semiconductor modules. Due to these characteristics, CuW has been used in a wide variety of semiconductor modules, such as the IC, LSI, power semiconductor, communication semiconductor, optical device, laser and sensor.

A semiconductor module which does not require silver soldering also needs to have an appropriate coefficient of linear expansion for the soldering of semiconductor devices as well as at the junction temperature. Having the maximum coefficient of linear expansion of 10 ppm/K or less within a temperature range from RT to 800°C, CuW has been free from the problems associated with the coefficient of linear expansion. Accordingly, CuW has been used in an even wider range of semiconductor modules.

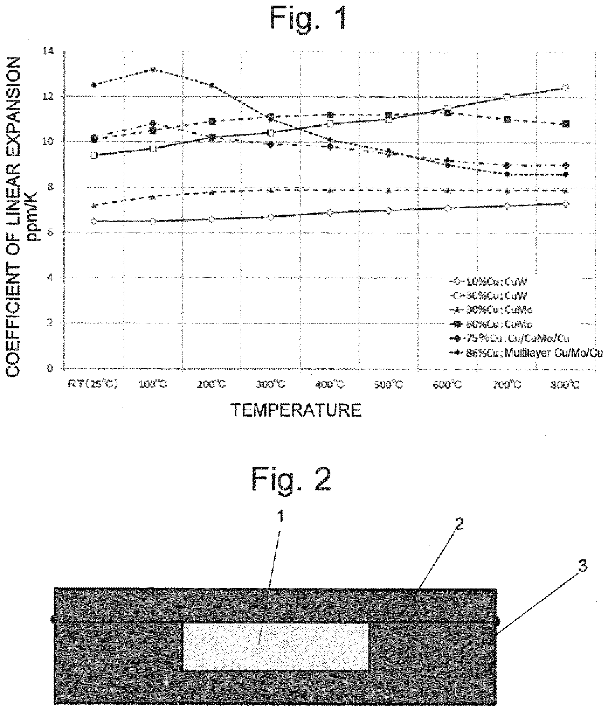

However, CuW has the problem that its thermal conductivity at RT is 200 W/m•K or lower, which is considerably lower than that of Cu. Accordingly, efforts have been made to improve its thermal conductivity. As one attempt to increase the thermal conductivity, CuW having the percentage of Cu increased to 30wt%Cu was developed (Fig. 1 and Table 1). However, the idea was not put to practical use since the coefficient of linear expansion exceeded 10 ppm/K when the temperature was high.

**Table 1**

| No | | Coefficient of Linear Expansion (ppm/K) | | Thermal Conductivity (W/m·K) | Blister Test Sample held in air at 400°C for 30 min. | |
|---|---|---|---|---|---|---|
| | wt%Cu | RT (25°C) | RT - 800°C (max.) | RT(25°C) | Multilayer Plating | Ditect Plating |
| 1 | Cu | 14.5 | 19 | 386 | ○ | ○ |
| 2 | W | 4.4 | 4.5 | 167 | ○ | NG |
| 3 | Mo | 5.2 | 5.8 | 159 | ○ | NG |
| 4 | 10%Cu;CuW | 6.5 | 7.3 | 180 | ○ | NG |
| 5 | 20%Cu;CuW | 8.3 | 9.8 | 200 | ○ | NG |
| 6 | 30%Cu;CuW | 9.4 | 12.4 | 251 | ○ | NG |
| 7 | 30%Cu;CuMo | 7.2 | 7.9 | 200 | ○ | NG |
| 8 | 40%Cu;CuMo | 8.7 | 9.2 | 222 | ○ | NG |
| 9 | 50%Cu;CuMo | 9.9 | 10.5 | 252 | ○ | NG |
| 10 | 60%Cu;CuMo | 10 | 11.3 | 270 | ○ | NG |
| 11 | 52%Cu;Cu/CuMo/Cu | 8.7 | 8.8 | 222 | ○ | ○ |
| 12 | 62%Cu;Cu/CuMo/Cu | 9.5 | 9.8 | 240 | ○ | ○ |
| 13 | 75%Cu;Cu/CuMo/Cu | 10.2 | 10.8 | 259 | ○ | ○ |
| 14 | 64Cu;Cu/Mo/Cu | 7.9 | 7.8 | 240 | ○ | ○ |
| 15 | 77Cu;Multilayer Cu/Mo/Cu | 10.1 | 11 | 277 | ○ | ○ |
| 16 | 86%Cu;Multilayer Cu/Mo/Cu | 12.5 | 13.2 | 321 | ○ | ○ |

CuMo has the advantage that Mo has a lower specific weight and lower powder price than W. However, CuMo has a low degree of wettability to Cu. Accordingly, if a CuMo substrate is produced by a liquid metal infiltration or sintering process, the relative density (the ratio of the actual density to a theoretical density calculated on the assumption that the raw material powder is fully densified) becomes low, so that the eventually obtained material cannot satisfy the requirements concerning the characteristics and qualities of heat dissipation substrates. To address this problem, a technique has been developed for producing a heat dissipation substrate having a relative density of 99% or higher and thermal conductivity of 200 W/m•K or higher by forging, hot pressing (HP), rolling or other methods and put to practical use (Table 1). However, CuMo also caused the problem that the coefficient of linear expansion exceeded 10 ppm/K at high temperatures in the case of a high thermal conductivity material having the percentage of Cu increased to a level of 50wt%Cu or higher (Table 1).

With the increase in the junction temperature for Si devices from 125°C to 175°C as a result of the performance improvement of the semiconductor modules due to technological advancements, the use of GaN or SiC devices which can operate under high temperatures has been studied. However, as far as the heat dissipation substrate is concerned, no specific temperatures and related values have been made public in regard to what level of thermal conductivity is needed at what temperature. In order to create substrates having a thermal conductivity of 250 W/m•K or higher at RT or 100°C as well as improve the quality of the Ni-based final plating, manufacturers of the heat dissipation substrate have developed clad materials, such as Cu/CuMo/Cu, Cu/Mo/Cu and multilayer Cu/Mo/Cu. However, it has been revealed that those highly heat-conductive materials cause problems concerning the life and performance of the semiconductor module due to various factors, such as a bimetal effect causing the substrate to warp, the presence of a high peak of the coefficient of linear expansion within a temperature range from 100°C to 200°C, which exceeds 10 ppm/K (Fig. 1), and a low thermal conductivity in the thickness direction due to the presence of the poorly heat-conductive Mo layer in the cross section.

The present inventor has tested heat dissipation substrates of conventionally developed CuW, CuMo and AlSiC, and examined the necessary characteristics.

Fig. 1 shows a graph of the relationship between the temperature and coefficient of linear expansion for representative heat dissipation substrates of CuW and CuMo. Table 1 shows the relationship among the coefficient of linear expansion of conventional heat dissipation substrates at RT, maximum coefficient of linear expansion within a temperature range from RT to 800°C, and thermal conductivity at RT.

The study result has demonstrated that a problem with the package production and/or the performance of the semiconductor module can occur in the case of a heat dissipation substrate having a maximum coefficient of linear expansion of 10 ppm/K or higher within a temperature range from RT to 800°C. As for the thermal conductivity of the heat dissipation substrate, it has been found that a high value is needed at the temperature which the heat dissipation substrate will have when the semiconductor device reaches the junction temperature.

The study has also demonstrated that none of the conventional heat dissipation substrate materials of CuW, CuMo and AlSiC can satisfy the requirements that the maximum coefficient of linear expansion should be 10 ppm/K or less within a temperature range from RT to 800°C and the thermal conductivity should be 250 W/m•K or higher within a temperature range from 100°C to 200°C, since the thermal conductivity of any of those conventional heat dissipation substrate materials additionally decreases when the temperature is higher than RT.

In recent years, GaN and SiC devices, whose junction temperature is as high as 200-225°C, have been in full-scale use. Heat dissipation substrates used in these devices are highly heat-conductive as well as large in size, so that the temperature of the heat dissipation substrate becomes lower than that of the semiconductor device. It has been revealed that the temperature of the heat dissipation substrate is around 200°C when the junction temperature is 225°C, which means that a heat dissipation substrate material having a high thermal conductivity at 200°C is required. Simultaneously, there is also a strong demand for a heat dissipation substrate having a coefficient of linear expansion of 10 ppm/K or less at 200°C in order to ensure the required performance of the semiconductor module.

As a result of the transition of the semiconductor devices to GaN or SiC, the junction temperature has become higher than 200°C and exceeded the upper limit of the temperature which allows for the use of resin materials. A semiconductor module which is designed in a special form including a package using a large-size heat dissipation substrate to prevent the module from reaching the upper-limit temperature for the resin material has been developed. However, such a module is large, expensive and uneconomical. To deal with such a problem, a package on which a ceramic or similar heat-resistant member is silver-soldered has been essential. CuW and CuMo are sufficiently heat resistant to allow for the silver soldering as with Cu. However, these materials are less heat conductive than Cu. With such a technical background, a heat dissipation substrate has been desired which has a thermal conductivity of 250 W/m•K or higher at 200°C while satisfying the requirement of the maximum coefficient of linear expansion being 10 ppm/K or less within a temperature range from RT to 800°C which is considered to be an optimum coefficient of linear expansion. At present, there is no such CuW or CuMo-based material for heat dissipation substrates.

AlSiC is not sufficiently heat-resistant for silver soldering. Furthermore, using AlSiC as a heat dissipation substrate for high-performance semiconductor modules causes a problem since the thermal conductivity of its main component (SiC) considerably decreases with an increase in the temperature.

Some of the metal-diamond-system materials for heat dissipation substrates satisfy the required characteristics. However, they also have problems, such as the difficulty in ensuring the quality of the Ni-based plating as well as their price being too high for practical use.

Another problem concerning the high-performance semiconductor module is that, if a considerable amount of voids is formed in the solder in the process of bonding a semiconductor device, the cooling efficiency is lowered, and a breakage or separation occurs due to the heat from the semiconductor device. To solve this problem while taking into account the fact that the surface area on which W or Mo in CuW or CuMo is exposed cannot be satisfactorily adhesive with the Ni-based final plating, a multilayer plating process is performed in which a thermal treatment is performed for each plating step so as to improve the adhesiveness. In this manner, the conventional CuW or CuMo requires the plating and heating processes to be performed a plurality of times to enable a high-quality Ni-based final plating on the surface of the heat dissipation substrate. Accordingly, a high amount of cost is needed for the plating.

### (Prior Art Search)

There are many reports on research and development activities performed thus far with the aim of improving the thermal conductivity of CuMo or CuW.

Patent Literature 1 discloses a semiconductor module of an LSI in which a heat dissipation substrate of CuW with 10wt%Cu is plated with Ni-P and silver-soldered onto a ceramic member.

Patent Literature 2 discloses a semiconductor module, produced by liquid metal infiltration, in which a ceramic member is joined to CuW with a relative density of 100 % and Cu content of 5-22 wt%. According to this document, a problem with the production or performance of the semiconductor module occurs if the amount of Cu is outside the specified range.

Patent Literature 3 discloses a heat dissipation substrate having an improved thermal conductivity in CuW formed by creating a skeleton using coarse powder of W with an increased amount of Cu, and subsequently infiltrating Cu into the skeleton.

However, creating CuW with a high relative density using coarse powder of W is an extremely difficult process. Additionally, although materials which contain Cu at a percentage of 30wt% or higher exhibit high thermal conductivities (Fig. 1), such materials have the problem that their coefficient of linear expansion at high temperatures is large, as with the conventional 30wt%CuW.

Patent Literature 4 discloses a heat dissipation substrate obtained by performing a rolling process on CuMo with a relative density of 90-98 % and Cu content of 10-70 wt% produced by a sintering process.

CuMo is inferior to CuW in thermal conductivity when it has the same coefficient of linear expansion as CuW. Additionally, in order to achieve an appropriate coefficient of linear expansion of 10 ppm/K or less (i.e. a suitable coefficient of linear expansion for semiconductor modules), CuMo needs to have a composition with a Cu content of 50 wt% or lower, which makes it difficult to create a composite material with a relative density of 90 % or higher by a sintering process.

Patent Literature 5 discloses a method for producing a plurality of heat dissipation substrates of Cu/Mo/Cu or Cu/W/Cu in a stacked form by hot pressing.

Patent Literature 6 discloses a heat dissipation substrate of Cu/CuW/Cu or Cu/CuMo/Cu as well as a semiconductor module using such a substrate.

Patent Literature 7 discloses a method for producing a heat dissipation substrate with a high good-product percentage (with few cracks or cleavage) obtained by producing a composite material having a relative density of 90 % or higher by a sintering process using Mo powder of 0.5-8 µm and Cu powder of 50 µm, and mono-axially and multi-axially rolling the same material at 650°C or higher temperature. However, this method does not always ensure a satisfactory quality of the rolled product, since the rolling process at 650°C or higher temperature causes oxidization of Cu or Mo on the surface layer as well as in the inner region, forming cracks. Additionally, the thermal conductivity is extremely unstable and unsuitable for use as a heat dissipation substrate.

Patent Literature 8 discloses a heat dissipation substrate having a coefficient of linear expansion of 12 ppm/K or less and thermal conductivity of 230 W/m•K or higher, obtained by producing CuMo by a sintering process, forging the sintered CuMo to increase its relative density, and rolling the forged CuMo. The document also discloses a semiconductor module using such a substrate.

However, a CuMo composite material having a low relative density becomes broken if it is cold-forged. On the other hand, hot forging does not always ensure a satisfactory quality of the rolled product, since it causes oxidization of Cu or Mo on the surface layer as well as in the inner region, allowing cracks to be easily formed. Additionally, the thermal conductivity is extremely unstable and unsuitable for use as a heat dissipation substrate.

Patent Literature 9 discloses a heat dissipation substrate having a coefficient of linear expansion of 7-12 ppm/K and thermal conductivity of 170-280 W/m•K as well as allowing for punching or 3D-shaping work, produced by forming a skeleton from Mo powder of 2-6 µm, infiltrating Cu into the skeleton by liquid metal infiltration to create CuMo with 20-60wt%Cu, and performing the cold or warm rolling process on this CuMo.

This method is only available under limited producing conditions; i.e., it is difficult to produce the substrate from Mo powder which does not fall within the range of 2-6 µm, such as Mo powder with a particle size of 1 µm or less, or Mo particles which exceed 6 µm. Additionally, no heat dissipation substrate obtained by this production method has the maximum coefficient of linear expansion of 10 ppm/K or less within a temperature range from RT to 800°C (which is considered to be an optimum coefficient of linear expansion) and thermal conductivity of 250 W/m•K or higher at a temperature of 200°C.

Patent Literature 10 discloses a clad-type heat dissipation substrate with Cu and Mo alternately layered as in Cu/Mo/Cu/Mo/Cu.... It is also reported that a small coefficient of linear expansion and high thermal conductivity can be achieved even with a small amount of Mo, while the surface layer made of Cu allows for high-quality plating.

However, regarding this material having a composition for a high thermal conductivity, although the coefficient of linear expansion has small values at high temperatures, there is a peak of the coefficient of linear expansion around a temperature range from 100-200°C, which exceeds the appropriate value of the coefficient of linear expansion, i.e. 10 ppm/K. Another problem is that the thermal conductivity in the thickness direction is lower than in the planer direction. Furthermore, if the clad material has an imbalance in the constituent layers, the bimetal effect becomes noticeable at high temperatures, causing the structure to warp, which unfavorably affects the performance and life of the device.

### CITATION LIST

### PATENT LITERATURE

Patent Literature 1: JP H04-340752 A
Patent Literature 2: JP H06-13494 A
Patent Literature 3: JP 2002-356731 A
Patent Literature 4: JP H05-1255407 A
Patent Literature 5: JP H06-268115 A
Patent Literature 6: JP H06-26117 A
Patent Literature 7: JP H10-72602 A
Patent Literature 8: JP H11-26966 A
Patent Literature 9: JP H11-307701 A
Patent Literature 10: JP 2010-56148 A

### SUMMARY OF INVENTION

### TECHNICAL PROBLEM

With the advancement in the performance of semiconductor modules, there is a strong demand for a heat dissipation substrate having a maximum coefficient of linear expansion of 10 ppm/K or less within a temperature range from RT to 800°C (which is a suitable coefficient of linear expansion for heat dissipation substrates for semiconductor modules) and thermal conductivity of 250 W/m•K or higher at 200°C, while allowing for the use of CuMo and CuW which are proven materials for heat dissipation substrates.

Conventional attempts to improve the thermal conductivity of CuW by increasing the percentage of Cu or using coarse powder have not yet been put into practical use due to the problem that such a high thermal conductivity material has a coefficient of linear expansion exceeding 10 ppm/K, i.e. the highest value suitable for heat dissipation substrates, at high temperatures.

Attempts to improve the thermal conductivity of CuMo by increasing the percentage of Cu or creating the substrate in the form of a clad material have only a limited range of applications for heat dissipation substrates due to the problem that such a high thermal conductivity material also has a coefficient of linear expansion exceeding 10 ppm/K, i.e. the highest value suitable for heat dissipation substrates, at high temperatures.

The present inventor has conducted technical research and measurements on various conventional types of CuMo or CuW-based heat dissipation substrates. Table 1 shows a graph of the relationship of the maximum coefficient of linear expansion within a temperature range from RT to 800°C as well as the thermal conductivity at RT.

None of those materials satisfy the requirement that the thermal conductivity should be 250 W/m•K or higher. Their thermal conductivities will further decrease as the temperature increases from RT to 100°C. The thermal conductivities will be at even lower levels when the temperature reaches 200°C. Accordingly, it has conventionally been believed that there is no possibility of finding a material which satisfies the requirement that the thermal conductivity should be 250 W/m•K or higher at 200°C.

### SOLUTION TO PROBLEM

To solve such problems, the present inventor has discovered that a heat dissipation substrate having the maximum value of the coefficient of linear expansion of 10 ppm/K or less in any direction in a plane parallel to the surface within a temperature range from RT to 800°C as well as a thermal conductivity of 250 W/m•K or higher at 200°C can be obtained by densifying an alloy composite of CuMo or CuW composed of Cu and coarse powder of Mo or W and subsequently cross-rolling the same alloy composite.

Thus, a heat dissipation substrate according to the present invention is characterized in that:
the main body is made of an alloy composite containing Mo or W and Cu as main components; and
the maximum coefficient of linear expansion in any direction in a plane parallel to the surface within a temperature range from 25°C to 800°C is equal to or less than 10 ppm/K, and the thermal conductivity at a temperature of 200°C is equal to or higher than 250 W/m•K.

A method for producing a heat dissipation substrate according to the present invention includes the steps of:
creating an alloy composite containing a mixture of particles of Mo or W and Cu as main components;
densifying the alloy composite; and
cross-rolling the alloy composite after the densifying step.

The "alloy composite" means an object having a certain self-supporting shape, such as an object created by compacting a mixture of metallic powder or particles or an object created by solidifying a mass of metallic powder or particles by pouring molten metal into it. For example, the alloy composite in the present invention can be created by compacting the aforementioned mixture of particles in a mold and sintering the obtained compact. Liquid metal infiltration or other methods may also be used for the creation of the alloy composite.

It has already been known that such characteristics as the electric conductivity or thermal conductivity can be improved by producing the alloy composite by a powder metallurgy process using coarse powder of Mo or W. However, it is extremely difficult to produce an alloy composite having a high relative density (the ratio of the actual density to a theoretical density calculated on the assumption that the raw material powder is fully densified) using coarse powder of Mo or W. Accordingly, the conventional process of creating a heat dissipation substrate requires using fine powder with a particle size of 10 µm or less and optimizing the production conditions. In the case of CuW, a heat dissipation substrate having a relative density of 99 % or higher and being usable as a heat dissipation substrate could be produced by liquid metal infiltration. In the case of CuMo, due to the low wettability of Cu to Mo, it was difficult to create a heat dissipation substrate having a relative density of 99 % or higher. Accordingly, an alloy composite having a relative density of 90 % or higher was initially prepared and subsequently subjected to a forging, rolling or similar process at high temperatures to obtain a heat dissipation substrate having a relative density of 99 % or higher.

When coarse powder of Mo or W is used, even the liquid metal infiltration of Cu can only produce an alloy composite with a low relative density. The relative density of the alloy composite will be even lower in the case of CuMo. Performing a warm or hot rolling process on such an alloy composite causes cracks or cleavage in its surface layer or end portions, with the consequent decrease in the amount of satisfactory portion obtained from the rolled material. This problem occurs due to the fact that performing a warm or hot rolling process on an alloy composite having a low relative density causes defects due to the lack of mechanical strength as well as due to the oxidization of Cu, Mo or W on the surface layer or in the inner region during the heating process.

Furthermore, in order to obtain a sufficiently dense alloy composite which allows for a satisfactory rolling process, a high pressure needs to be applied under high temperature. Such an operation requires a large system, which makes it extremely difficult to create a large-sized alloy composite.

In particular, CuMo is lighter than CuW, and Mo powder is inexpensive. However, compared to W, Mo has a lower degree of wettability to Cu, which means that, if coarse powder of Mo is used, it is difficult to obtain an alloy composite by liquid metal infiltration or sintering, which allows for a rolling process. Therefore, CuMo is more difficult to be produced by a rolling process. However, as compared to CuW, CuMo uses a less expensive raw material (Mo), allows for the creation of a lighter heat dissipation substrate, and has been most popularly used. Therefore, there is a strong demand for a CuMo-based heat dissipation substrate having the maximum value of the coefficient of linear expansion of 10 ppm/K or less within a temperature range from RT to 800°C and thermal conductivity of 250 W/m•K or higher at 200°C. As for CuW, which is highly machine-workable, a heat dissipation substrate which can be used for 3D-shaped products has been demanded.

The present inventor has created samples of CuMo with 40wt%Cu using 60-µm Mo powder by both liquid metal infiltration and sintering. After the surface layer was removed from those alloy composites, a warm cross-rolling process at 450°C with a low percentage of rolling reduction was repeated. A measurement sample was cut out from a satisfactory portion of each of the obtained rolled materials, and its coefficient of linear expansion and thermal conductivity were measured. The result confirmed that there was no significant difference in the measured values between the alloy composite obtained by liquid metal infiltration and the one obtained by sintering.

However, due to the cracking and oxidization inside the rolled material, the thermal conductivities of those samples were considerably lower than that of a sample of conventional CuMo with 40wt%Cu. Meanwhile, in order to examine the plating quality, a blister test was performed: Initially, as with the conventional CuMo, the alloy composites were thermally treated. Subsequently, one group of alloy composites were subjected to a multilayer plating process including the processes of 5-µm Ni-plating, thermal treatment, and 3-µm Ni-B plating, while another group were subjected to a 3-µm Ni-B direct plating process to form a single-layer plating. The two groups of plated samples were held in the air at 400°C for 30 minutes. As a result, a number of blisters were formed. The cause of the blistering was found to be an oxidization of the surface layer of the heat dissipation substrate, which led to the detachment of Mo, formation of burrs and other defects during the thermal treatment.

CuW alloy composites were also created by both liquid metal infiltration and sintering. After the rolling process, the samples were examined. The result was similar to the one obtained with CuMo.

Similarly to the previously described case, samples of CuMo with 40wt%Cu were created by both liquid metal infiltration and sintering, using 60-µm Mo powder. After their surface layer was removed, each alloy composite was canned in a sealed case of stainless steel (which is hereinafter abbreviated as "SUS") for the prevention of oxidization (Fig. 2). The canned alloy composites were cross-rolled at 800°C to obtain alloy composites having relative intensities of 99 % or higher. The obtained alloy composites were removed from the SUS cases and solid-phase sintered at 950°C for 60 minutes in hydrogen atmosphere to reduce oxides and repair defects which occurred in the rolling process. Subsequently, a Cu-plating layer with a thickness of 10 µm was formed, and a warm cross-rolling process at 450°C was repeated. As a finishing process, a thermal treatment was performed at 400°C for 10 minutes in hydrogen atmosphere, followed by a moderate cold rolling process to smooth their surfaces. A sample was cut out from each of the materials created by both liquid metal infiltration and sintering, and its coefficient of linear expansion and thermal conductivity were measured. While the coefficient of linear expansion was not significantly different from that of the conventional CuMo with 40wt%Cu, the thermal conductivity showed a considerable improvement. Additionally, a blister test was performed: Initially, the alloy composites were thermally treated. Subsequently, one group of alloy composites were subjected to a multilayer plating process including the processes of 5-µm Ni-plating, thermal treatment, and 3-µm Ni-B plating, while another group were subjected to a 3-µm Ni-B direct plating process to form a single-layer plating. The two groups of plated samples were held in the air at 400°C for 30 minutes. No blister was recognized.

CuW alloy composites were also created by both liquid metal infiltration and sintering. After the densification, Cu-plating and rolling processes, the samples were examined. The result was similar to the one obtained with CuMo.

### ADVANTAGEOUS EFFECTS OF THE INVENTION

According to the present invention, a material which satisfies the requirement that the maximum value of the coefficient of linear expansion should be 10 ppm/K or less in any direction in a plane parallel to the surface within a temperature range from RT to 800°C and a thermal conductivity at 200°C should be 250 W/m•K or higher can be obtained by densifying an alloy composite of CuMo or CuW composed of Cu and coarse powder of Mo or W and subsequently cross-rolling the same alloy composite after solid-phase sintering.

As for the quality of the Ni-based final plating, if there is a Cu layer on the surface, the Ni-based final plating process can be directly and economically performed, as with the heat dissipation substrate of Cu.

By the production method according to the present invention, it is possible to obtain a heat dissipation substrate of CuMo or CuW having a high thermal conductivity and a low coefficient of linear expansion while allowing for the plating process to be easily performed.

The present invention provides, as a novel idea, the technique of obtaining a heat dissipation substrate of CuMo or CuW having a small coefficient of thermal expansion and high thermal conductivity by cross-rolling CuMo or CuW created using coarse powder of Mo or W.

Even a semiconductor module using a package which does not require silver soldering needs to allow for a soldering process and junction temperature. The heat dissipation substrate of CuMo or CuW according to the present invention has a suitable coefficient of linear expansion for such modules and high thermal conductivity. Therefore, it can be used in a wide variety of semiconductor modules, such as the memory, IC, LSI, power semiconductor, communication semiconductor, optical device, laser and sensor.

Table 2 shows the maximum coefficient of linear expansion within a temperature range from RT to 800°C and thermal conductivity at 200°C for various examples of the heat dissipation substrate of CuMo or CuW according to the present invention, along with the values of comparative materials.

**Table 2**

| **No** | | **Particle Size of Mo and W (*µ*m)** | **Production Method** | **Densification Rolled+ Sintered** | **Metal Layer Thickness (*µ*m)** | **Rolling Method** | **Coeccifient of Linear Expansion (ppm/K)** | **Thermal Conductivity (W/m·K)** | **Blister Test Sample held in air at 400°C for 30 min.** | |
|---|---|---|---|---|---|---|---|---|---|---|
| | **wt%Cu** | | | | | | **RT∼800°C(max)** | **200°C** | **Multilayer Plating** | **Ditect Plating** |
| **Developed Products;CuMo** | | | | | | | | | | |
| **1** | **25%Cu;CuMo** | **150** | Sintering | Yes | **10** | Cross | **7.5** | **245** | **○** | **○** |
| **2** | **30%Cu;CuMo** | **150** | Sintering | Yes | **10** | Cross | **8.0** | **251** | **○** | **○** |
| **3** | **30%Cu;CuMo** | **200** | Sintering | Yes | **10** | Cross | **7.9** | **252** | **○** | **○** |
| **4** | **40%Cu;CuMo** | **60** | Infiltration | No | **0** | Cross | **9.8** | **170** | **NG** | **NG** |
| **5** | **40%Cu;CuMo** | **60** | Sintering | No | **0** | Cross | **9.9** | **165** | **NG** | **NG** |
| **6** | **40%Cu;CuMo** | **60** | Infiltration | Yes | **10** | Cross | **9.2** | **295** | **○** | **○** |
| **7** | **40%Cu;CuMo** | **60** | Sintering | Yes | **10** | Cross | **9.1** | **293** | **○** | **○** |
| **8** | **40%Cu;CuMo** | **60** | Sintering | Yes | **0** | Cross | **9.0** | **294** | **○** | **NG** |
| **9** | **40%Cu;CuMo** | **60** | Sintering | Yes | **3** | Cross | **9.2** | **293** | **○** | **○** |
| **10** | **40%Cu;CuMo** | **60** | Sintering | Yes | **10** | Mono-Axis | **11.0** | **293** | **○** | **○** |
| **11** | **50%Cu;CuMo** | **150** | Sintering | Yes | **10** | Cross | **9.9** | **340** | **○** | **○** |
| **12** | **50%Cu;CuMo** | **60** | Sintering | Yes | **0** | Cross | **9.8** | **310** | **○** | **NG** |
| **13** | **50%Cu;CuMo** | **15** | Sintering | Yes | **10** | Cross | **9.9** | **293** | **○** | **○** |
| **14** | **50%Cu;CuMo** | **12** | Sintering | Yes | **10** | Cross | **9.9** | **245** | **○** | **○** |
| **15** | **50%Cu;CuMo** | **6** | Sintering | Yes | **10** | Cross | **9.9** | **242** | **○** | **○** |
| **16** | **55%Cu;CuMo** | **150** | Sintering | Yes | **10** | Cross | **10.4** | **341** | **○** | **○** |
| **Developed Products;CuW** | | | | | | | | | | |
| **17** | **15%Cu;CuW** | **60** | Sintering | Yes | **10** | Cross | **7.2** | **246** | **○** | **○** |
| **18** | **20%Cu;CuW** | **60** | Infiltration | Yes | **10** | Cross | **7.5** | **260** | **○** | **○** |
| **19** | **20%Cu;CuW** | **60** | Sintering | Yes | **10** | Cross | **7.5** | **258** | **○** | **○** |
| **20** | **30%Cu;CuW** | **60** | Sintering | Yes | **10** | Cross | **8.8** | **305** | **○** | **○** |
| **21** | **40%Cu;CuW** | **60** | Sintering | Yes | **10** | Cross | **9.9** | **350** | **○** | **○** |
| **22** | **45%Cu;CuW** | **60** | Sintering | Yes | **10** | Cross | **10.6** | **355** | **○** | **○** |
| **Compared Products;Existing Products** | | | | | | | | | | |
| **23** | **Cu** | - | - | - | - | - | **19.0** | **373** | **○** | **○** |
| **24** | **W** | - | - | - | - | - | **4.5** | **148** | **○** | **NG** |
| **25** | **Mo** | - | - | - | - | - | **5.8** | **135** | **○** | **NG** |
| **26** | **20%Cu;CuW** | - | - | - | - | - | **9.8** | **193** | **○** | **NG** |
| **27** | **40%Cu;CuW** | - | - | - | - | - | **9.2** | **213** | **○** | **NG** |
| **28** | **62%Cu;Cu/CuMo/Cu** | - | - | - | - | - | **9.8** | **217** | **○** | **○** |
| **29** | **64Cu;Cu/Mo/Cu** | - | - | - | - | - | **7.8** | **230** | **○** | **○** |
| **30** | **77Cu:Multilayer Cu/Mo/Cu** | - | - | - | - | - | **11.0** | **249** | **○** | **○** |

### BRIEF DESCRIPTION OF DRAWINGS

Fig. 1 is a graph showing the relationship between the temperature and the coefficient of linear expansion of representative heat dissipation substrates of CuW and CuMo.
Fig. 2 is a cross sectional view of a structure canned in a SUS case.

### DESCRIPTION OF EMBODIMENTS

### (Raw Material)

By using CuMo or CuW prepared using coarse powder of Mo or W, a heat dissipation substrate having a high thermal conductivity can be created. In the present embodiment, at least 90 % of the particles of Mo or W need to have a particle size within a range from 15 µm to 200 µm. In other words, up to 10 % of the entire amount of powder may have a particle size outside this range. If more than 10 % of the particles have a size of 15 µm or less, it is impossible to achieve the state where the coefficient of linear expansion has an appropriate value of 10 ppm/K or less and the thermal conductivity is 250 W/m•K or higher at 200°C. If more than 10 % of the particles have a size of 200 µm or larger, only a minor improvement in the thermal conductivity can be achieved, while the powder price becomes considerably high. As for the Cu powder, there is no specific requirement, although electrolytic copper powder having a particle size within a range from 5 µm to 10 µm is preferable.

### (Composition)

Both CuMo and CuW may have any composition as long as the obtained material has (1) a suitable coefficient of linear expansion for semiconductor modules and (2) a high thermal conductivity. Mixture of W and Mo is also permissible as long as the required characteristics concerning the coefficient of linear expansion and thermal conductivity are satisfied.

As for the additive metal, it has already been reported that adding an appropriate kind of metal improves the performance of the liquid metal infiltration or sintering process. There is no specific requirements concerning the kind and quantity of metallic element to be added as long as the obtained material has (1) a suitable coefficient of linear expansion for semiconductor modules and (2) a high thermal conductivity. However, the addition of metal is actually unrecommendable, since some kind of metal decreases the thermal conductivity. Accordingly, in the present embodiment, a high level of thermal conductivity is achieved without using additive metal, although this increases the difficulty of the creation of the alloy composite.

### (Alloy Composite)

In the case of using Cu and coarse powder of Mo or W, either the liquid metal infiltration or sintering process may be used to create CuMo or CuW. Whichever method is used, there will be no significant difference in the characteristics or the like as long as an alloy composite having a relative density of 99 % or higher after the rolling process is obtained using powder of Mo or W having almost the same particle size. The more economical method can be chosen.

### (Densification)

A dense alloy composite having a high relative density is needed to obtain a heat dissipation substrate by cross-rolling. The densification may be achieved by any method. Densification of CuMo or CuW to a relative density of 99 % or higher normally requires high temperature and high pressure. For example, such methods as hot pressing or forging can be used, although these methods uneconomically require a large system. Hot forging is also unfavorable since it causes oxidization of Cu, Mo or W on the surface layer as well as in the inner region of the alloy composite.

By comparison, densifying the alloy composite by a hot rolling process followed by solid-phase sintering is an effective method, since the subsequent manufacturing process is also a rolling process (i.e. a cross-rolling process, which will be described later). However, if the alloy composite has a low relative density, a measure for preventing its oxidization is required, otherwise its surface layer or inner region will undergo oxidization during the rolling process. A solution to this problem is to contain the alloy composite in a SUS case for the prevention of oxidization and circumferential cracking, and deaerate and roll this case, whereby an alloy composite which is densified to a relative density of 99 % or higher and suitable for the subsequent cross-rolling process can be obtained. The process of densifying the alloy composite to a relative density of 99 % or higher can be controlled by optimizing the processing conditions by a preliminary experiment. The canning of the alloy composite minimizes circumferential breakage or cracking, whereby the yield of the cross-rolling process is improved. The solid-phase sintering of this alloy composite at a temperature equal to or lower than the melting point of Cu in hydrogen atmosphere repairs the separation of the particle surfaces of Mo or W and Cu as well as reduces oxides which occurs due to the residual oxygen. Thus, a suitable alloy composite for rolling is obtained. A preferable condition of the solid-phase sintering is to hold the alloy composite in hydrogen atmosphere at a temperature equal to or higher than 800°C and lower than the melting point of Cu (or lower than the melting points of all kinds of metal used as the main components of the alloy composite) for 60 minutes. Such a solid-phase sintering allows for a satisfactory rolling process, with the result that a dense heat dissipation substrate which does not allow blisters or similar defects of the alloy composite to occur even under a high temperature of 800°C for silver soldering can be obtained.

Another possible method for obtaining a suitable alloy composite for cross-rolling is to use an alloy composite with a low relative density and repeatedly perform a cross-rolling process with a low percentage of rolling reduction and a solid-phase sintering process until the relative density becomes 99 % or higher. However, this method is time-consuming as well as uneconomical.

### (Cu-Plating on Surface Layer)

As in the case of CuMo or CuW having a Mo content of 50 % or lower or W content of 60 % or lower with the balance being Cu, if the Cu content is considerably high, it is not always necessary to plate the surface layer with Cu in the rolling process. However, with a decrease in the Cu content, the area where the particles of Mo or W are in contact with or overlap each other increases, causing such phenomena as the detachment of the particles of Mo or W, or formation of burrs, during the rolling process. Such a problem can be addressed by plating the surface layer with Cu before the rolling process. From an economical point of view, the plating thickness should preferably be equal to or less than 10 µm. However, the plating may become ineffective if its thickness is as small as 3 µm or even thinner. Although the plating layer becomes thinner through the rolling process, the final Ni-plating can be satisfactorily performed if the Cu layer which eventually remains has a thickness of approximately 1 µm over the entire surface.

It is also possible to increase the thickness of the Cu plating so as to create a clad structure, similar to Cu/CuMo/Cu or Cu/CuW/Cu. A clad structure is a structure in which one or a plurality of metallic layers are formed on each of the obverse and reverse surfaces of an alloy composite. The use of the heat dissipation substrate having such a clad structure improves the compatibility with the Ni-based plating process which is performed in the final processing of the heat dissipation substrate (i.e. the degree of adhesion of the Ni-based plating), thus enabling the production of a heat dissipation substrate having a high-quality Ni-based plating.

### (Cross-Rolling)

In the cross-rolling process, the alloy composite placed in a non-oxidizing or reducing atmosphere and heated to 300°C or a higher temperature is alternately rolled in the X-axis and Y-axis directions (where both X and Y axes are defined in a plane parallel to the surface, with the thickness direction defined as the Z axis). The cross-rolling decreases and stabilizes the maximum coefficient of linear expansion within a temperature range from RT to 800°C in any direction in the plane parallel to the surface (i.e. not only the X-axis and Y-axis directions in which the cross-rolling is performed, but also in other directions in the plane) as well as improves and stabilizes the thermal conductivity. A simple mono-axial rolling is not suitable for a heat dissipation substrate, since a considerable difference in the coefficient of linear expansion occurs between the direction in which the cross-rolling is performed (e.g. X-axis direction) and the perpendicular direction (Y-axis direction). It is preferable to alternately perform the cross-rolling in the X-axis and Y-axis directions. By such a cross-rolling process, the particles of Mo or W distributed inside the alloy composite are shaped into a disk-like flat form in a plane parallel to the surface of the heat dissipation substrate. The percentage of rolling reduction of the alloy composite (i.e. the percentage of rolling reduction by the two processes of densifying and cross-rolling) at this stage is within a range from 50 % to 80 %. As already noted, at least 90 % of the particles of Mo or W have a particle size within a range from 15 µm to 200 µm. Accordingly, with the shape of each particle of Mo or W approximated by a sphere (with a volume of 4/3*π*r³, where r is the radius of the sphere) and that of each particle after the cross-rolling (percentage of rolling reduction, P) approximated by a disk-like flat body (with a volume of r×(1-P)×*π*r'³, where r' is the radius of the circular bottom face of the disk-like flat body after the cross-rolling), the size of the particles in a plane parallel to the surface of the heat dissipation substrate after the cross-rolling will be within a range from approximately 17 µm (which is the size in the case of using spherical particles with a radius of 15 µm as the raw material and performing the cross-rolling process with a percentage of rolling reduction of 50 %) to approximately 366 µm (which is the size in the case of using spherical particles with a radius of 200 µm as the raw material and performing the cross-rolling process with a percentage of rolling reduction of 80 %).

According to past performance records, there will be no problem in practical use if the difference in the coefficient of linear expansion between the X-axis and Y-axis directions is equal to or less than 20 %, whereas a difference greater than 20 % puts some restrictions on the use. By an appropriate selection of the raw materials and their composition as well as the shape of the used powder of Mo or W, along with an optimization of the cross-rolling conditions, a heat dissipation substrate having the required characteristics can be obtained.

The cross-rolling may be performed in any order in the X-axis and Y-axis directions, and any number of times, as long as the difference in the coefficient of linear expansion between the X-axis and Y-axis directions of the obtained heat dissipation substrate becomes equal to or less than 20 %. In the present embodiment, the rolling is performed in two orthogonal directions (X-axis and Y-axis directions). However, the objective of the cross-rolling is to achieve a coefficient of linear expansion of 10 ppm/K or less in any direction in a plane parallel to the surface as well as decrease the anisotropy in the coefficient of linear expansion. As long as this objective is achieved, the cross-rolling does not always need to be performed in two orthogonal directions but may be performed in any two or more non-parallel directions (i.e. two or more mutually intersecting directions).

In an alloy composite with a relative density of 99 % or higher, if its thickness is decreased to one fifth or less of the thickness before the rolling process, the flattened Mo or W may possibly be split into pieces, causing a variation in the coefficient of linear expansion and thermal conductivity. Accordingly, the rolling process should preferably be discontinued at a thickness greater than one fifth of the thickness of the alloy composite before the rolling process.

The rolling process may be any of the cold, warm and hot rolling processes. Cold rolling is not productive since a high percentage of rolling reduction cannot be achieved. For CuMo, a warm rolling process performed around 400°C is preferable. For CuW, a hot rolling process performed around 600°C is preferable. The quality of the rolled product can be improved by performing an acid cleaning, reduction treatment, buffing or similar process for each rolling operation in order to remove oxides from the surface layer. By performing a cold rolling process after a thermal treatment in hydrogen atmosphere, a finished product which has a smooth surface and is suitable for a heat dissipation substrate can be obtained.

### (Final Plating)

Although Mo and W are not always easy to be plated with metal, the Ni-based final plating is performed in order to prevent Cu in CuMo or CuW from being eroded in the silver-soldering or soft-soldering process. For high-grade products, Au-plating may additionally be performed on the Ni-based final plating in order to improve the quality of the soldering of the semiconductor device as well as enhance the commercial value. It should be noted that the term "Ni-based plating" means plating with Ni or Ni alloy.

For a heat dissipation substrate made of Cu, a Ni-based one-time direct plating process with no thermal treatment is sufficient. In the case of CuMo or CuW, since the area where Mo or W is exposed cannot be easily plated with metal, a multilayer plating process needs to be performed, such as thermal treatment + Ni-plating + thermal treatment + Ni-plating. Such a process requires a long period of time, causing a long delivery time and an increased production cost. In the case of the heat dissipation substrate of the present embodiment, although the multilayer plating process can be similarly performed, a Ni-based one-time direct plating process may be sufficient in the case where the Cu-plating layer formed before the rolling process still remains.

### (Other Remarks)

In a semiconductor module, the quality of the solder joint portion between the heat dissipation substrate and the semiconductor device is essential. The void percentage in this portion must meet a strict condition. Most commonly used solder materials for semiconductor devices are AuSn (melting point, 280°C) and AuSi (melting point, 363°C), both of which are in conformity with the requirements of the Pb-free production and high-temperature operation. For a semiconductor device which needs to withstand 200°C or higher temperatures, an even higher quality is desired. In such a case, the device may be soldered onto an Au-plated heat dissipation substrate.

Ni-based final plating methods which are suited for Cu, CuMo and CuW have already been developed. In the present invention, if a Cu plating layer is present, a 3-µm Ni-B final plating process can be directly performed, and its quality can be controlled by a blister test. Meanwhile, a multilayer Ni-based final plating as in the conventional CuMo or CuW is also frequently desired. In such a case, the blister test can be similarly used for the check and control of the quality. It has been commonly known that a product which has passed a blister test will not cause any problem concerning the silver soldering, solder joint or practical use.

### <Evaluation of Heat Dissipation Substrate>

### (Measurement of Coefficient of Linear Expansion)

From each alloy composite obtained by the previously described cross-rolling process, a sample measuring 10 mm in the X-axis direction, 4 mm in the Y-axis direction and 2-2.5 mm in thickness (Z-axis direction) was cut out by wire electrical discharge machining (hereinafter abbreviated as the "WEDM"). Using a device for measuring coefficient of linear expansion (manufactured by Seiko Instruments Inc.), the coefficient of linear expansion within a temperature range from RT to 800°C was measured in both X-axis and Y-axis directions, and the larger value was adopted.

### (Measurement of Thermal Conductivity)

From each alloy composite obtained by the previously described cross-rolling process, a sample measuring 10 mm in diameter and 2-2.5 mm in thickness was cut out by WEDM. Using a laser-flash thermal conductivity meter (TC-7000, manufactured by Advance Riko, Inc.), the thermal conductivity was measured at 200°C in hydrogen atmosphere.

### (Blister Test on Plating)

A multilayer Ni-plating process and single-layer direct plating process were performed on samples measuring 5 mm × 25 mm. After those samples were held in the air at 400°C for 30 minutes, the appearance of each sample was observed with a stereoscopic microscope at 10-fold magnification. Samples which had no blister on the metallic plating layer were judged to be "OK", while samples on which a blister was recognized were judged to be "NG", regardless of the size of the blister.

### EXAMPLE

### (Example 1: CuMo with 40wt%Cu; liquid metal infiltration, densification and rolling; Sample No. 6)

Mo powder with an average particle size of 60 µm was mixed with 3 wt% of electrolytic copper powder with an average particle size of 10 µm and 1 wt% of paraffin wax. The obtained mixed powder was press-molded in a 50-mm × 50-mm mold. The molded object was heated at 600°C for 60 minutes in hydrogen atmosphere to remove wax. The same object was further heated to 1000°C in hydrogen atmosphere to obtain a skeleton. A Cu plate was placed on this skeleton and heated at 1250°C for 60 minutes in hydrogen atmosphere to infiltrate molten Cu into the skeleton. In this manner, a CuMo alloy composite measuring 50 mm × 50 mm × 6 mm with 40wt%Cu was created. Residues of the infiltration Cu on surface layer of the alloy composite as well as defects on the surface layer were removed by cutting work. After the alloy composite was contained in a SUS case and deaerated, the ends of the case were welded to complete the canning. The canned alloy composite was cross-rolled at 800°C. After the relative density of the alloy composite reached a level of 99 % or higher, the alloy composite was removed from the case and solid-phase sintered at 950°C for 60 minutes in hydrogen atmosphere. The solid-phase-sintered (or densified) alloy composite was subjected to a 10-µm Cu-plating process, and subsequently warm-cross-rolled at 400°C until the thickness was reduced to 2 mm. That is to say, the percentage of rolling reduction of the two-stage cross-rolling process was 66.6 % (=(6 mm-2 mm) / 6 mm).

After an additional thermal treatment was performed at 450°C for 15 minutes in hydrogen atmosphere, the alloy composite was cold-rolled to smooth its surface.

Some of the heat dissipation substrates obtained in this manner were subjected to the multilayer Ni-based plating process, while others were subjected to the single-layer direct Ni-plating process. The blister test was performed on both groups.

The coefficient of linear expansion and thermal conductivity of each sample were also measured.

The result is shown in Table 2.

### (Example 2: CuMo with 40wt%Cu; sintering, densification and rolling; Sample No. 7)

Mo powder with an average particle size of 60 µm was mixed with electrolytic copper powder with an average particle size of 10 µm to prepare a mixed powder having a Cu content of 40 wt%, with the balance being Mo. The obtained mixed powder was press-molded in a 50-mm × 50-mm mold. The molded object was liquid-phase sintered at 1250°C for 60 minutes in hydrogen atmosphere to obtain a CuMo alloy composite measuring 50 mm × 50 mm × 6 mm. Defects on the surface layer of the alloy composite were removed by cutting work. After the alloy composite was contained in a SUS case and deaerated, the ends of the case were welded to complete the canning. The canned alloy composite was cross-rolled at 800°C. After the relative density of the alloy composite reached a level of 99 % or higher, the alloy composite was removed from the case and solid-phase sintered at 950°C for 60 minutes in hydrogen atmosphere. The sintered alloy composite was subjected to a 10-µm Cu-plating process and subsequently cross-rolled at 400°C to obtain a plate material with a thickness of 2 mm. That is to say, the percentage of rolling reduction of the two-stage cross-rolling process was 66.6 % (=(6 mm-2 mm) / 6 mm). The plate material was thermally treated at 450°C for 15 minutes in hydrogen atmosphere and subsequently cold-rolled to smooth its surface.

Some of the heat dissipation substrates obtained in this manner were subjected to the multilayer Ni-based plating process, while others were subjected to the single-layer direct plating process. The blister test was performed on both groups.

The coefficient of linear expansion and thermal conductivity of each sample were also measured.

The result is shown in Table 2.

### (Example 3: CuW with 45wt%Cu; sintering and rolling; Sample No. 20)

Mo powder with an average particle size of 60 µm was mixed with electrolytic copper powder with an average particle size of 10 µm to prepare a mixed powder having a Cu content of 45 wt%, with the balance being Mo. The obtained mixed powder was press-molded in a 50-mm × 50-mm mold. The molded object was liquid-phase sintered at 1250°C for 60 minutes in hydrogen atmosphere to obtain a CuMo alloy composite measuring 50 mm × 50 mm × 6 mm.

Defects on the surface layer of the alloy composite were removed by cutting work. After the alloy composite was contained in a SUS case and deaerated, the ends of the case were welded to complete the canning. The canned alloy composite was cross-rolled at 800°C. After the relative density of the alloy composite reached a level of 99 % or higher, the alloy composite was removed from the case and solid-phase sintered at 1000°C for 60 minutes in hydrogen atmosphere. The sintered alloy composite was subjected to a 10-µm Cu-plating process and subsequently cross-rolled at 600°C until the thickness was reduced to 2 mm. That is to say, the percentage of rolling reduction of the two-stage cross-rolling process was 66.6 % (=(6 mm-2 mm) / 6 mm).

Some of the heat dissipation substrates obtained in this manner were subjected to the multilayer Ni-based plating process, while others were subjected to the single-layer direct plating process. The blister test was performed on both groups.

The coefficient of linear expansion and thermal conductivity of each sample were also measured.

The result is shown in Table 2.

### (Example 4: Evaluation of a semiconductor module having a semiconductor device mounted on a heat dissipation substrate in a package)

Using the heat dissipation substrate of Example 2 having a coefficient of linear expansion of 9.1 ppm/K and thermal conductivity of 293 W/m•K, a package was created by silver-soldering members made of ceramic, Kovar and other materials onto the heat dissipation substrate in hydrogen atmosphere at 800°C. It was checked that neither separation nor cracking was present on the package. The metallic electrode layer of a Si device measuring 10 mm ×10 mm × 0.7 mm was joined onto this package, using a high-temperature AuSi solder (melting point, 363°C) at 400°C, to obtain a semiconductor module. By an ultrasonic measurement, it was confirmed that the percentage of the void area in the solder joint portion was not higher than 3 %. In general, when the final plating is a 3-µm Ni-B plating, the SnAgCu solder (melting point, 218°C) needs to pass an extremely stringent evaluation test which requires the void percentage measured by ultrasonic measurement to be 5 % or lower. It is commonly known that any material which satisfies this requirement causes no problem in silver soldering, other kinds of soldering, resin adhesion or the like. The voids formed in the soldering process reflect pinholes which are present on the surface of the heat dissipation layer before the Ni-based final plating process is performed. In other words, the evaluation condition for SnAgCu (melting point, 218°C) can be satisfied by using a heat dissipation substrate on which the percentage of the pinholes (defects) is equal to or lower than 5 %. In Example 4, the void percentage is not higher than 3 %. Thus, all of the aforementioned requirements are satisfied.

A heat cycle test module (-40°C to 225°C, 3000 times) was performed on the same semiconductor. Meanwhile, for comparison, another package was created using a conventional heat dissipation substrate of CuMo with 40wt%Cu in the same size, with a coefficient of thermal expansion of 9.1 ppm/K (the same as in Example 2) and thermal conductivity of 213 W/m•K. After the devices were mounted on this package, the heat cycle test (-40°C to 225°C, 3000 times) was similarly performed.

The result confirmed that separation, cracking or other problems did not occur on any of the two samples.

### (Interpretation of Present Disclosure - 1)

By the present invention, a high-performance heat dissipation substrate which satisfies the requirements for use with future high-performance semiconductor modules can be obtained.

### (Interpretation of Present Disclosure - 2)

The present invention is not limited to the previous embodiment. Any mode of modification will also be included in the present invention as long as the objective of the present invention is thereby achieved. Specific structures, modes or the like for carrying out the present invention may also be altered as long as the objective of the present invention is thereby achieved.

The presently disclosed embodiment and examples should be considered, in all aspects, as mere examples of non-restrictive nature. The subject matter is as set forth in claims and should not be limited to the previous descriptions.

### REFERENCE SIGNS LIST

1... Alloy Composite Created by Liquid Metal Infiltration or Sintering Process
2... SUS Canning Case
3... Circumferentially Welded Joint Portion

## Claims

1. A production method for a heat dissipation substrate, comprising steps of:
creating an alloy composite using Cu and particles of Mo or W as main components;
densifying the alloy composite; and
cross-rolling the alloy composite after the densifying step.

2. The production method for a heat dissipation substrate according to claim 1, wherein:
the densified alloy composite are solid-treated before the cross-rolling step.

3. The production method for a heat dissipation substrate, **characterized in that**:
a heat dissipation substrate having a maximum value of a coefficient of linear expansion of 10 ppm/K or less in any direction in a plane parallel to a surface within a temperature range from RT to 800°C as well as a thermal conductivity of 250 W/m•K or higher at 200°C is created by steps of:
creating an alloy composite of CuMo or CuW using Cu and particles of Mo or W as main components, with at least 90 % of the particles having a size within a range from 15 µm to 200 µm;
densifying the alloy composite to increase a relative density of the alloy composite;
solid-phase sintering the alloy composite after the densifying step; and
cross-rolling the alloy composite after the solid-phase sintering step.

4. The production method for a heat dissipation substrate according to one of claims 1-3, wherein:
the densifying step is performed by rolling the alloy composite to increase the relative density of the alloy composite to 99 % or a higher level.

5. The production method for a heat dissipation substrate according to claim 4, wherein:
the rolling is performed on the alloy composite in a canned and deaerated state.

6. The production method for a heat dissipation substrate according to one of claims 1-5, wherein:
a metallic plating process is performed on the densified alloy composite before the cross-rolling step.

7. The production method for a heat dissipation substrate according to one of claims 1-6, wherein:
the cross-rolling is a warm, hot or cold cross-rolling process or a combination of these kinds of cross-rolling.

8. A heat dissipation substrate including, as a main body, an alloy composite using Cu and particles of Mo or W as main components, wherein:
a maximum coefficient of linear expansion in any direction in a plane parallel to the surface within a temperature range from 25°C to 800°C is equal to or less than 10 ppm/K, and a thermal conductivity at 200°C is equal to or higher than 250 W/m•K.

9. The heat dissipation substrate according to claim 8, wherein:
the particles of Mo or W distributed inside the heat dissipation substrate have a flat shape spread in a plane parallel to a surface of the heat dissipation substrate, with at least 90 % of the particles of Mo or W having a maximum diameter in the aforementioned plane within a range from 17 µm to 366 µm.

10. The heat dissipation substrate according to claim 8 or 9, wherein:
a metallic layer having a thickness of 1 µm or greater is formed on a surface of the alloy composite.

11. The heat dissipation substrate according to claim 8 or 9, wherein:
one or a plurality of metallic layers are formed on each of obverse and reverse surfaces of the alloy composite.

12. A semiconductor package, comprising the heat dissipation substrate according to one of claims 8-11.

13. A semiconductor module, comprising the heat dissipation substrate according to one of claims 8-11.

14. A semiconductor module, comprising the heat dissipation substrate according to one of claims 8-11 having a surface on which a solder joint with a void percentage of equal to or lower than 5 % is formed via a Ni-based plating.
